Europäisches Patentamt

European Patent Office

Office européen des brevets

(11) Veröffentlichungsnummer: **0 432 612 A2**

# EUROPÄISCHE PATENTANMELDUNG

(21) Anmeldenummer: **90123129.0**

(22) Anmeldetag: **03.12.90**

(51) Int. Cl.5 **H01L 21/263, H01L 21.322**

(30) Priorität: **09.12.89 DE 3940723**

(43) Veröffentlichungstag der Anmeldung:
**19.06.91 Patentblatt 91/25**

(84) Benannte Vertragsstaaten:
**DE SE**

(71) Anmelder: **EUPEC Europäische Gesellschaft für Leistungshalbleiter mbH & Co. KG
Max-Planck-Strasse 5
W-4788 Warstein/Belecke(DE)**

(72) Erfinder: **Kaussen, Franz, Dr.
Brucknerweg 29
W-4788 Warstein(DE)**
Erfinder: **Köhler, Werner
Am Oberhagen 13
W-4788 Warstein(DE)**

(74) Vertreter: **Fuchs, Franz-Josef, Dr.-Ing. et al
Postfach 22 13 17
W-8000 München 22(DE)**

(54) **Verfahren zur Erzeugung von Ladungsträgerlebensdauerprofilen in einem Halbleiter.**

(57) Gegenstand der Erfindung ist ein Verfahren zur Erzeugung vertikaler und/oder lateraler Profile der Ladungsträgerlebensdauer der Minoritätsladungsträger in einem Halbleiter.

Die Ladungsträgerlebensdauer wird in dem gesamten Halbleiter in bekannter Weise mittels Elektronen- oder Gammastrahlen durch Erzeugen von Gitterfehlstellen erniedrigt. Anschliessend wird die Ladungsträgerlebensdauer durch Zufuhr von Wärme an vorgegebenen Stellen des Halbleiters auf einen vorbestimmten Wert erhöht, wobei die Erhöhung der Ladungsträgerlebensdauer durch Ausheilen der durch die Bestrahlung erzeugten Fehlstellen bewirkt wird.

FIG.1a

FIG.1b  FIG.1c

EP 0 432 612 A2

# VERFAHREN ZUR ERZEUGUNG VON LADUNGSTRÄGERLEBENSDAUERPROFILEN IN EINEM HALBLEITER

Die Erfindung betrifft ein Verfahren zur Erzeugung vertikaler und/oder lateraler Profile der Ladungsträgerlebensdauer der Minoritätsladungsträger in einem Halbleiter unter Einwirkung von Elektronen- oder Gammastrahlen.

Bei der Herstellung von Halbleiterbauelementen ist es von besonderer Bedeutung, vertikale und/oder laterale Profile der Ladungsträgerlebensdauer der Minoritätsladungsträger zu erzeugen. Beispielsweise werden die Schalteigenschaften von pin-Dioden dadurch verbessert, dass eine Rekombinationsschicht in der Umgebung des $p+n$-übergangs erzeugt wird. Bei Kommutierung wird der pn-übergang infolgedessen schnell von Ladungsträgern freigeräumt, so dass sich bei vorgegebener Abkommutierungssteilheit eine kleine Rückstromspitze ergibt. Derartige Rekombinationsschichten lassen sich durch Bestrahlung mit hochenergetischen Protonen erzeugen. Die Herstellung derartiger vertikaler Profile ist jedoch sehr kostenaufwendig und lässt sich nur im Labormassstab durchführen.

Andererseits ist es bei der Herstellung von Thyristoren oder Leistungstransistoren mit integrierter Freilaufdiode erforderlich, laterale Lebensdauerprofile einzustellen. Die Einstellung lateraler Profile erfolgt bisher durch Elektronenbestrahlung unter Verwendung von Masken aus Molybdän. Als nachteilig ist hierbei anzusehen, dass in der Regel die Bestrahlung mit hochenergetischen Elektronen nicht in den eigenen Fertigungsstätten durchgeführt werden kann. Andererseits findet eine Unterstrahlung der Masken statt, so dass sich nur sehr unscharfe laterale Profile einstellen lassen, die zumindest beim Aufbau eines Bauelements durch monolithische Integration mehrerer Komponenten mit unterschiedlichen Lebensdauerwerten den technischen Anforderungen nicht genügen.

Der Erfindung liegt die Aufgabe zugrunde, ein Verfahren zur Erzeugung vertikaler und/oder lateraler Profile der Ladungsträgerlebensdauer der Minoritätsladungsträger in einem Halbleiter verfügbar zu machen, das die Herstellung derartiger Profile unter fertigungstechnisch günstigen Bedingungen ermöglicht und mit dem die monolithische Integration von Bauelementen mit unterschiedlicher Lebensdauer realisierbar ist.

Diese Aufgabe wird gemäss der Erfindung dadurch gelöst, dass die Ladungsträgerlebensdauer in dem gesamten Halbleiter durch Bestrahlung mit Elektronenstrahlen oder Gammastrahlen durch Erzeugung von Gitterfehlstellen erniedrigt wird und dass anschliessend die Ladungsträgerlebensdauer durch Zufuhr von Wärme an vorgegebenen Stellen des Halbleiters auf einen vorbestimmten Wert erhöht wird, wobei die Erhöhung der Ladungsträgerlebensdauer durch Ausheilen der durch die Bestrahlung erzeugten Fehlstellen bewirkt wird.

Der besondere Vorteil des Verfahrens besteht darin, dass praktisch das gleiche Verfahren, nämlich zunächst die Erzeugung von Fehlstellen und dann das gezielte Ausheilen dieser Fehlstellen sowohl zur Erzeugung von vertikalen als auch lateralen Profilen der Ladungsträgerlebensdauer eingesetzt werden kann.

Ein besonders vorteilhaftes Verfahren zur vertikalen Einstellung der Ladungsträgerlebensdauer in einer Halbleiterscheibe besteht darin, dass auf der einen Seite der Halbleiterscheibe Wärme abgeführt und auf der anderen Seite Wärme zugeführt wird derart, dass sich ein bestimmtes vertikales Ladungsträgerlebensdauerprofil durch Wahl der Oberflächentemperaturen auf den gegenüberliegenden Seiten der Halbleiterscheibe einstellt.

Zur Einstellung eines lateralen Profils wird dieses Verfahren dahingehend abgewandelt, dass die Halbleiterscheibe auf der einen Seite ebenfalls gekühlt wird und auf der anderen Seite der Halbleiterscheibe über eine oder mehrere Blenden mit Infrarotstrahlen bestrahlt wird, so dass nur in den nicht ausgeblendeten Bereichen der Halbleiterscheibe die Ladungsträgerlebensdauer erhöht wird. Die Blenden bzw. die Maske können entfallen, wenn die Oberfläche der Halbleiterscheibe anstatt mit Infrarotstrahlen stellen- oder bereichsweise mit Laserstrahlen bestrahlt wird.

Weiterbildungen der Erfindung sind den Unteransprüchen zu entnehmen.

Das Wesen der Erfindung soll anhand einiger in den Zeichnungen dargestellter Ausführungsbeispiele näher erläutert werden.

Es zeigen:

Fig. 1a in schematischer Darstellung eine Einrichtung zur Einstellung eines vertikalen Lebensdauerprofils in einer Siliciumscheibe mittels Infrarotstrahlen;

Fig. 1b den Temperaturverlauf in Abhängigkeit zu der Endstufe X der Infrarotstrahlen in der Halbleiterscheibe bei geringer Absorption;

Fig. 1c das vertikale Ladungsträgerlebensdauerprofil bei geringer Absorption und

Fig. 2 eine Einrichtung zur Einstellung eines lateralen Profils der Ladungsträgerlebensdauer, wobei gleichzeitig auch ein vertikales Profil entsteht.

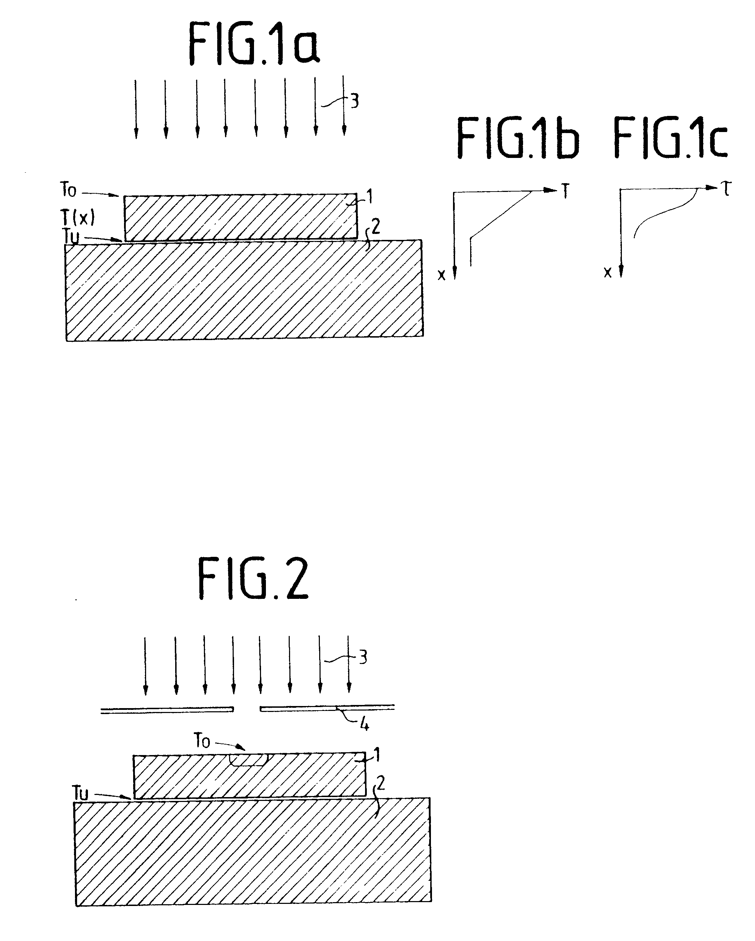

Die mit γ- oder Strahlen bestrahlte Siliciumscheibe 1 ist auf ihrer Unterseite mit einer ganzflächigen Kühleinrichtung in Kontakt. Die Oberseite der Siliciumscheibe wird mit Infrarotstrahlen bestrahlt, welche durch die Pfeile 3 dargestellt sind. Durch die Kühlung wird die Unterseite der Siliciumscheibe auf einer Temperatur Tu gehalten, während die Oberseite die Temperatur To annimmt, die im wesentlichen von der Intensität der Strahlung und der Wellenlängen der Infrarotstrahlung abhängt. Entsprechend der Temperaturdifferenz zwischen der Ober- und Unterseite stellt sich ein Temperaturprofil ein, wie es aus Fig. 1b zu entnehmen ist, wenn X der Abstand von der Oberseite der Siliciumscheibe zur Unterseite hin ist. Durch unterschiedliche Wärmezu- oder -abfuhr über der Scheibenfläche lassen sich parallel zueinander unterschiedliche Ladungsträgerprofile herstellen.

Die Ausheilung der durch die Bestrahlung erzeugten Gitterfehlstellen tritt bei Temperaturen zwischen 350 und 450 ˚ C auf. Je höher die Temperatur, umso stärker ist die Erhöhung der Ladungsträgerlebensdauer. In den Bereichen der Siliciumscheibe, in denen die Temperatur unter 350 ˚ C liegt, tritt kaum eine Veränderung im Wert der Ladungsträgerlebensdauer mehr auf.

Die Eindringtiefe der Infrarotstrahlung ist abhängig von der Wellenlänge, und zwar nimmt die Absorption mit zunehmender Wellenlänge ab und damit die Eindringtiefe zu. In Figur 1b ist der Fall mit relativ grosser Absorption dargestellt. Dementsprechend ergibt sich ein Ladungsträgerlebensdauerprofil gemäss Figu 1c. Bei kleiner Absorption wird in einer dickeren Oberflächenschicht die Temperatur To erhöht, wodurch sich ein sehr starkes Profil der Lebensdauer ergibt. Zwischen diesen beiden Grenzfällen ist jedes bisherige Profil einstellbar.

Mit einem Lebensdauerprofil gemäss Fig. 1c lassen sich beispielsweise die Schalteigenschaften schneller Dioden erheblich verbessern. Da dies bisher nur mit Alpha- oder Protonenbestrahlung möglich war, stellt das Verfahren gemäss der Erfindung eine wesentliche Vereinfachung der Fertigungstechnik bezüglich der Einstellung eines Ladungsträgerlebensdauerprofils dar.

Bei dem Ausführungsbeispiel nach Fig. 2 wird die Halbleiterscheibe 1 zunächst ebenso wie bei dem Ausführungsbeispiel nach Fig. 1 durchgehend mit Elektronen- oder Gammastrahlen bestrahlt derart, so dass sich eine homogene Verteilung von Gitterfehlstellen einstellt, welche die Lebensdauer auf einen vorbestimmten Wert erniedrigt.

Die Halbleiterscheibe 1 ist auf ihrer Unterseite ebenfalls wieder mit einer Kühlung 2 versehen, während die Oberseite über eine Blende 4 mit durch die Pfeile dargestellten Infrarotstrahlen bestrahlt wird. Im Falle einer kreisrunden Blendenöffnung stellt sich in einem begrenzten Oberflächenbereich auf der Halbleiterscheibe die Temperatur To ein, während die Temperatur auf der Unterseite Tu über die Temperatur ganzflächig konstant gehalten wird.

Erfolgt die Bestrahlung ohne Kühlung nur relativ kurzzeitig, so wird die Erhöhung der Ladungsträgerlebensdauer nur in einem oberflächennahen Bereich wirksam. Bei gleichzeitiger Kühlung und längerer Strahlungseinwirkung stellt sich entsprechend Fig. 1b ein konstanter Temperaturgradient ein, der neben der lateralen Begrenzung der Ladungsträgerlebensdauer auch noch das entsprechende vertikale Profil aufweist.

Wie bereits eingangs erwähnt. lässt sich ein laterales Profil auch dadurch einstellen. dass die Halbleiteroberfläche über eine laterale Maske mit Elektronenstrahlen bestrahlt wird. Durch Unterstrahlung der Maske werden jedoch nur sehr unscharfe Ränder erhalten. d. h. es ergeben sich gegebenenfalls Abweichungen bis zu 5 mm. Bei der Infrarotbestrahlung über Blenden oder Masken hingegen lassen sich, gegebenenfalls unter Einsatz geeigneter optischer Hilfsmittel, sehr scharfe laterale Strukturen erreichen. Derartige laterale Strukturen sind insbesondere dann erforderlich, in einer Siliciumscheibe monolithisch mehrere Bauelemente integriert werden sollen. In diesen Fällen wird die Strukturschärfe nur durch die laterale Wärmeleitung bestimmt und liegt etwa in der Grössenordnung die Scheibendicke.

Laterale Strukturen lassen sich unter Wegfall der Blenden bzw. Masken durch Bestrahlung mit Laserstrahlen realisieren. Bei zusätzlicher Kühlung lassen sich dann auch gezielt gleiche vertikale Ladungsträgerlebensdauerprofile einstellen. Bei vorgegebener Kühlung lassen die Profile durch die Strahlungsintensität und die Wellenlänge der Laserstrahlen modifizieren.

## Ansprüche

1.  Verfahren zur Erzeugung vertikaler und oder lateraler Profile der Ladungsträgerlebensdauer der Minoritätsladungsträger in einem Halbleiter,
    **dadurch gekennzeichnet,**
    dass die Ladungsträgerlebensdauer in dem gesamten Halbleiter in bekannter Weise mittels Elektronen- oder Gammastrahlen durch Erzeugen von Gitterfehlstellen erniedrigt wird und dass anschliessend die Ladungsträgerlebensdauer durch Zufuhr von Wärme an vorgegebenen Stellen des Halbleiters auf einen vorbestimmten Wert erhöht wird, wobei die Erhöhung der Ladungsträgerlebensdauer durch Ausheilen der durch die Bestrahlung erzeugten Fehlstellen bewirkt wird.

2. Verfahren nach Anspruch 1,
**dadurch gekennzeichnet,**
dass zur vertikalen Einstellung der Ladungsträgerlebensdauer in einer Halbleiterscheibe auf der einen Seite der Halbleiterscheibe Wärme abgeführt und auf der anderen Seite Wärme zugeführt wird derart, dass sich ein bestimmtes vertikales Ladungsträgerlebensdauerprofil durch Wahl der Oberflächentemperaturen auf den gegenüberliegenden Seiten der Halbleiterscheibe einstellt.

3. Verfahren nach Anspruch 2,
**dadurch gekennzeichnet,**
dass die Halbleiterscheibe auf der einen Seite ganzflächig gekühlt und auf der gegenüberliegenden Seite ganzflächig mit konstanter Energie bestrahlt wird, so dass die Ladungsträgerlebensdauer von der bestrahlten Oberfläche her in das Innere der Halbleiterscheibe abnimmt.

4. Verfahren nach Anspruch 2 oder 3,
**dadurch gekennzeichnet,**
dass die Wärme durch Infrarotstrahlung erzeugt wird und das Ladungsträgerlebensdauerprofil bei vorgegebener Kühlung durch Wahl der Bestrahlungsintensität und der Wellenlänge eingestellt wird.

5. Verfahren nach Anspruch 1,
**dadurch gekennzeichnet,**
dass zur lateralen Einstellung der Ladungsträgerlebensdauer in einer Halbleiterscheibe eine Seite der Halbleiterscheibe über eine oder mehrere Blenden kurzzeitig mit Infrarotstrahlen bestrahlt werden, so dass nur in den nicht ausgeblendeten oberflächennahen Bereichen der Halbleiterscheibe die Ladungsträgerlebensdauer erhöht wird.

6. Verfahren nach Anspruch 1,
**dadurch gekennzeichnet,**
dass zur lateralen Einstellung der Ladungsträgerlebensdauer in einer Halbleiterscheibe eine Seite der Halbleiterscheibe stellen- oder bereichsweise mit Laserstrahlen bestrahlt wird.

7. Verfahren nach Anspruch 1,
**dadurch gekennzeichnet,**
dass zur vertikalen und horizontalen Einstellung der Ladungsträgerlebensdauer in einer Halbleiterscheibe diese auf der einen Seite gekühlt und von der anderen Seite her über eine oder mehrere Blenden mit Infrarotstrahlen bestrahlt wird derart, dass sich in den durch die Blenden vorgegebenen lateralen Bereichen ein bestimmtes Ladungsträgerlebensdauerprofil bei vorgegebener Kühlung durch die Bestrahlungsintensität und die Wellenlänge der Infrarotstrahlung eingestellt wird.

8. Verfahren nach Anspruch 1,
**dadurch gekennzeichnet,**
dass zur vertikalen und horizontalen Einstellung der Ladungsträgerlebensdauer in einer Halbleiterscheibe diese auf der einen Seite gekühlt und auf der anderen Seite stellen- oder bereichsweise mit Laserstrahlen bestrahlt wird derart, dass das Ladungsträgerlebensdauerprofil bei vorgegebener Kühlung durch die Bestrahlungsintensität und Wellenlänge der Laserstrahlen eingestellt wird.

9. Verfahren nach einem der Ansprüche 1 bis 8,
**dadurch gekennzeichnet,**
dass die vorgegebenen Stellen des Halbleiters zur Erhöhung der Ladungsträgerlebensdauer auf eine Temperatur zwischen 350 und 450 ° C erwärmt werden, wobei bei der unteren Temperatur praktisch keine Ausheilung stattfindet, während die grösste Lebensdauererhöhung bei etwa 450 ° C stattfindet.

10. Verfahren nach einem der Ansprüche 1 bis 9,
**dadurch gekennzeichnet,**
dass als Halbleitermaterial Silicium verwendet wird.

# FIG.1a

To

T(x)

Tu

1

2

3

# FIG.1b  FIG.1c

T

x

τ

x

# FIG.2

3

4

To

Tu

1

2